(19) **Europäisches Patentamt / European Patent Office / Office européen des brevets**

(11) **EP 1 916 767 B1**

(12) **EUROPEAN PATENT SPECIFICATION**

(45) Date of publication and mention
of the grant of the patent:
**29.12.2010 Bulletin 2010/52**

(51) Int Cl.:
***H03H 21/00*** *(2006.01)*

(21) Application number: **06022336.9**

(22) Date of filing: **25.10.2006**

(54) **A method and an apparatus for reducing interference frequencies by using a notch filter**

Verfahren und Vorrichtung zur Reduzierung von Interferenzfrequenzen mit einem Kerbfilter

Procédé et appareil de réduction de fréquences d'interférence par l'utilisation d'un filtre coupe-bande

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**30.04.2008 Bulletin 2008/18**

(73) Proprietor: **Istituto Superiore Mario Boella
10138 Torino (IT)**

(72) Inventors:
• **Mulassano, Paolo
10141 Torino (IT)**
• **Borio, Daniele
10093 Collegno (TO) (IT)**
• **Camoriano, Laura
10073 Cirie (TO) (IT)**

(74) Representative: **Grünecker, Kinkeldey,
Stockmair & Schwanhäusser
Anwaltssozietät
Leopoldstrasse 4
80802 München (DE)**

(56) References cited:
**WO-A-01/78242      US-A- 3 967 102**

• **LASTER D ET AL: "INTERFERENCE REJECTION IN DIGITAL WIRELESS COMMUNICATIONS" IEEE SIGNAL PROCESSING MAGAZINE, IEEE SERVICE CENTER, PISCATAWAY, NJ, US, vol. 14, no. 3, May 1997 (1997-05), pages 37-62, XP011089773 ISSN: 1053-5888**

**Description**

The present invention generally relates to digital signal processing techniques and more particularly relates to the suppression of one or more CW interfering frequencies in a digital input signal, such as down-converted signals of a global positioning system.

In an increasing number of technical fields data have to be transmitted via communication channels, which may result in a significant signal distortion due to the characteristics of the communication channel. For example, wireless channels may be used for data transfer, which are particularly prone to interference mechanisms, wherein significant efforts may be required to recover the information of the signal at the receiver side, while not unduly contributing to data redundancy at the transmitter side. Thus, efficient filter regimes may be used to suppress interfering signal components at the receiver, while not unduly adding additional interference caused by the filtering process. Due to the wide-spread availability of digital signal processing techniques, highly efficient digital filter units may be implemented in a plurality of systems. Digital filters may be provided in the form of adaptive filter units, in which the respective filter parameters may be "continuously" updated or adapted to the current situation so as to provide an optimum filter result despite of varying conditions.

For example, the currently growing demand for services based on precise position and accurate navigation information is driving the development of new receivers for global positioning systems with increased sensitivity. That is, the receivers preferably have the capability of detecting extremely weak signals and are equipped with multi-path and interference mitigation units. The presence of interference rejection units can extremely improve the receiver performance. Thus there is an increasing demand for providing highly efficient interference rejection regimes not only in professional receivers for which the computational power is not an issue, but also for public use in order to enhance precision and reliability of low-cost systems. For those reasons the design of computationally efficient and low cost interference mitigation units is obtaining an increasing attention in particular from the GNSS community.

One of the dominant contributors to interference in the field of satellite based signals is the so called continuous wave (CW) interference, that includes all those narrow band signals that can be reasonably represented as pure sinusoids with respect to the Galileo/GPS bands. This kind of interfering signals can be generated by UHF and VHF TV, VOR (VHF (Very High Frequency) Omni-directional Radio-range) and ILS (Instrument Landing System) harmonics, by spurious signals caused by power amplifiers working in the non-linearity region or by oscillators present in many electronic devices. For this kind of disturbing signals the notch filter has proven to be an efficient mitigation technique, due to its capability of attenuating the CW interferer, while preserving the Galileo/GPS power spectral density. In the literature different works concerning the design of computationally efficient notch filters are present. For example, V. Calmettes, R. J. Landry, and M. Bousquet, in "impact of interference on a generic GPS receiver and assessment of mitigation techniques", IEEE 5th International Symposium on Spread Spectrum Techniques and Applications, pp. 87-91, September 1998, introduce a one-pole notch filter as an efficient theoretical means for estimating performance characteristics when suppressing a hypothetic complex interferer. Moreover, an estimation of mitigation techniques is presented by V. Calmettes, F. Pradeilles, and M. Bousquet in "Study and comparison of interference mitigation techniques for GPS receiver", ION GPS, Salt Lake City, UT, September 2001.

Different kinds of notch filters have been used in the past in order to reduce the impact of narrow band interference on spread spectrum signals including GPS signals. From a general standpoint notch filters are filters that strongly attenuate a very narrow portion of the signal frequencies while essentially preserving the other components.

An example of a notch filter can be found in WO 01/78242 A2.

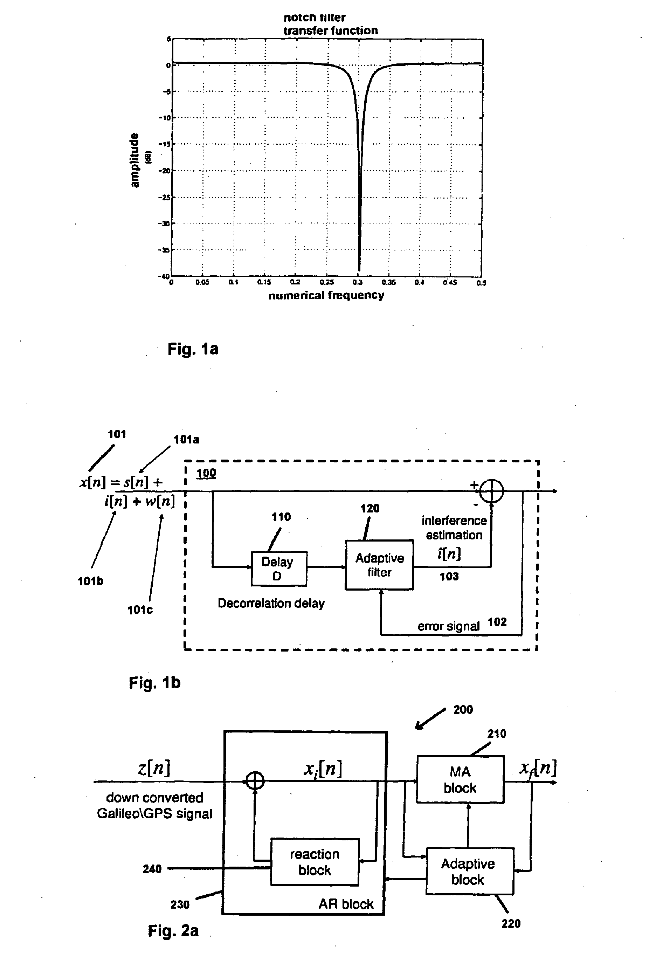

Fig. 1 a schematically illustrates an example of frequency response. As is evident, the presence of a zero in the transfer function of the single-pole notch filter causes the mitigation of the frequency components corresponding to the zero's phase, whereas the other filter parameters are chosen in order to preserve the other input signal elements. Even though it is possible to design notch filters in the analog domain, the majority of the applications are in the digital one, due to the fact that adaptive blocks may readily be implemented. Consequently, adaptive notch filters may represent promising filter components for many applications, such as suppressing CW interferers in GPS signals.

Therefore, different classes of notch filters are reported in the literature, wherein the major part of these filters is essentially based on the estimation of the interference, which may then be subtracted from the received signal, as for instance disclosed by V. K. Ingle and J. G. Proakis, in "Digital Signal Processing Using MATLAB", the PWS Book Ware Companion Series, PWS Publishing Company, 1997.

Fig. 1b schematically shows this principle. A mitigation filter 100 comprises an adaptive filter 120 including an adaptive algorithm. A delay unit 110 provides a delayed version of the received signal 101, which contains a useful signal component 101a, an interference 101b and a noise component that is assumed to be an additive white Gaussian noise 101c. The delayed signal is supplied to the adaptive filter 120 along with a residual error contribution 102 to determine an appropriate estimation of the interference 103 that is then subtracted from the incoming signal 101. The delay block 110 is introduced to reduce the correlation between the input samples 101 entering directly the adaptive filter 120 and the samples of the error signal 102. The incoming signal 101 can be considered as a wideband signal with respect to the interference 101b, so that a delay of only one sample is sufficient for having decorrelation; accordingly, D usually equals 1. The most prominent classes of these kinds of notch filters are adaptive transversal FIR (finite impulse response) filters in time domain, namely:

- FFT (Fast Fourier Transformation) -based FIR filters;
- Constrained poles and zeros IIR (infinite impulse response) notch filters;
- unconstrained zeros IIR notch filters.

The first class of notch filters is based on a FIR filter whose taps are iteratively evaluated by different adaptive algorithms, such as the direct inversion matrix method proposed by R. Rifkin and J.J. Vaccaro in "Comparison of narrowband adaptive filter technologies for GPS", technical report, MITRE Corporation, www.mitre.org, March 2000; and the LMS (Least Mean Square) algorithm of V. K. Ingle and J. G. Proakis, "Digital Signal Processing Using MATLAB", the PWS Book Ware Companion Series, PWS Publishing Company, 1997.

These algorithms do not have stability problems but are computationally complex, since the number of taps, required for a thin notch, is relatively high resulting in a high number of additions/multiplications. The direct inversion matrix technique also requires significant computational resources.

The FFT-based FIR filters exploit the efficiency of the FFT algorithm in order to evaluate a spectral estimation of the signal components. When a frequency component passes a fixed threshold a CW interference is considered detected at this frequency and is then reduced by the notch. Then the processed signal is inverse FFT-transformed into the time domain. Such a technique corresponds to circular filtering, and the equivalent impulse response presents notches in correspondence of the cancelled components. This method presents the advantage of not requiring a detection criterion that is already implemented in the frequency domain (threshold).

The wider class of the notch filters reported in literature relates to the constrained poles and zeros IIR notch filters. In this case the overall interference suppression filter has the following transfer function:

$$H_n(z) = \prod_{i=1}^{N} \frac{1 - \exp\{j2\pi f_i\}z^{-1}}{1 - k_a \exp\{j2\pi f_i\}z^{-1}}$$

where N is the number of interference signals, $k_a$ the contraction factor of the poles and $\{f_i\}$ the interference frequencies. In this case the zeros are constrained to be on the unit circle, thereby cancelling the signal components at the frequencies $\{f_i\}$. The pole contraction factor $k_a$ constrains the poles' modulus to be $k_a$, thereby regulating the notch width of the transfer function. Different works studied this kind of filter behaviour, considering their steady state performances. See for instance R. V. Raja Kumar and R.N. Pal. "Tracking of bandpass signals using centre-frequency adaptive filters", IEEE Transactions on Acoustics, Speech, and Signal Processing, vol. 38(10);pp. 1710-1721, October 1990; or P. Stoica and A. Nehorai, "Performance analysis of an adaptive notch filter with constrained poles and zeros", IEEE Transactions on Acoustics, Speech and Signal Processing, vol. 36(6);pp. 911-919, June 1988.

However the main problem is that suitable detection algorithms are required in order to deactivate the notch filter when the interference is not present. In "Piranha filter for communication system robustness", by R. Jr Landry, V. Calmettes, and M. Bousquet, IEEE international Conference on Acoustics, Speech, and Signal Processing, ICASSP, vol. 3;pp. 1517 -1520, March 1999, an autoregressive filter is coupled with the constrained poles and zeros IIR notch filters. In this case the first filter detects and estimates the interference frequency while the second cancels it.

The last class of filters especially tailored for GPS was first proposed by Calmettes et al. In this case a single zero/pole filter is employed having the transfer function:

$$H_n(z) = \frac{1 - z_0 z^{-1}}{1 - k_a z_0 z^{-1}}$$

The position of the zero $z_0$ is no longer constrained on the unit circle and also its modulus is adaptively determined.

Since these filter classes, except the FFT-based, may have a significant influence in terms of performance loss in the absence of an interfering signal, typically a detection method is required that should be coupled with the mitigation unit. However, the detection of the interference signal may necessitate additional hardware and/or software resources, thereby significantly contributing to the overall complexity, resulting in the costs of efficient interference mitigation systems increasing.

It is therefore an object of the present invention to provide an enhanced technique for interference suppression by means of a notch filter, while avoiding or at least reducing one or more of the above identified problems.

According to one aspect of the present invention this object is solved by an adaptive notch filter that comprises a two-pole filter stage connected to receive a digital input signal and to output a filtered digital output signal and the sequence of $z_0$. The filter further comprises an adaptive unit configured to adjust a complex zero of the two-pole filter stage on the basis of a real frequency component of an interference signal. Finally, an interference detection control unit is provided and connected to receive a signal corresponding to the output sequence of $z_0$, wherein the interference detection control unit comprises a deactivation criterion based on a convergence behaviour of the complex zero for bypassing the two-pole filter stage when the deactivation criterion is met.

Thus, the present invention provides a two-pole filter stage that may efficiently compensate for interfering real single frequency components in an digital input signal, wherein the two symmetric interfering frequencies are effectively mitigated by the zero and the complex conjugate thereof. Hence, real interfering signals may be tracked by correspondingly adapting the phase and the modulus of the zero and the complex conjugate thereof. Furthermore, the convergence behaviour of the zeros can advantageously be used for deciding whether or not the interfering frequency is present. Hence, depending on the deactivation criterion obtained by the filter itself, the filtered output signal or the initial input signal may be used for the further processing, thereby significantly reducing any adverse effects on the input signal when a pronounced interfering signal is not present.

In a further advantageous embodiment the deactivation criterion is represented by a threshold value for the modulus of the complex zero. The notch filter zeros may be selected so as to not be restricted to the unit circle in the complex plane, which provides the possibility to exploit the behaviour of the magnitude of the complex zero with respect to its behaviour in the presence or absence of an interfering signal. Thus, without significant computational resources a reliable estimation of the strength and thus of the presence or "absence" of the interfering signal may be obtained.

In a further embodiment the adaptive notch filter further comprises a low pass filter stage connected to receive the output sequence of $z_0$ and to provide the signal to the interference detection control unit. In this manner variations of the filtered output samples may be averaged, thereby enhancing the stability and reliability of the decision on the presence or absence of the interfering frequency.

In a further embodiment the two-pole filter stage comprises a moving average block for suppressing the real frequency component of the interference signal, and an autoregressive block for compensating a suppression of frequency components other than the real frequency component.

Hence, the effect of the two zeros on the remaining initial signal in the presence of an interferer may at least partially be reduced, thereby substantially maintaining desired small signal components.

In a further embodiment the moving average block is defined by a first transfer function including the real part of the zero and the square of the zero, whilst the autoregressive block is defined by a second transfer function substantially corresponding to an inverse of the first transfer function including a weighting factor for the complex zero.

The weighting factor having a magnitude less than 1 may therefore adjust the width of the resulting notches in the spectrum, while also scaling the degree of compensation.

In one illustrative embodiment the first transfer function is implemented as a first divider including a first delay stage coupled to a first multiplier, and a second divider connected to the first divider and including a second delay stage, wherein the second divider is coupled to a second multiplier. Thus, the corresponding filter transfer function may effectively implemented as hardware and/or software components without adding to substantial process complexity.

For example, the first multiplier multiplies by two times the real part of the complex zero, and the second multiplier multiplies by the square of the magnitude of the complex zero.

In a further preferred embodiment the adaptive notch filter further comprises at least one further two-pole filter stage connected to receive the output signal as input and to output a further output signal, wherein the adaptive unit is configured to adjust a phase and a magnitude of a further zero of the at least one further two-pole filter stage corresponding to a further real frequency component of the interference signal, wherein the further real frequency component differs from the real frequency component detected in the two-pole filter stage. Moreover, the interference detection control unit is connected to receive a further signal corresponding to the further output sequence of $z_0$, and the interference detection control unit comprises a further deactivation criterion based on a convergence behaviour of the further zero of the at least one further two-pole filter stage for bypassing the at least one further two-pole filter stage when the further deactivation criterion is met.

Thus, two or more two-pole filter stages may be provided in a cascade, thereby providing the potential to detect and track a plurality of interfering frequency components. Since each of the at least one further two-pole filter stages may be deactivated when a respective interfering signal component is not detected, a number of filter stages may be activated that is equal to the number of effective interfering frequencies, thereby avoiding any undue influence on the performance of the filter. Thus, a multi-pole notch filter system may be provided, wherein the number of active filter stages corresponds to the number of interfering frequencies, wherein each interfering frequency may individually be tracked.

Advantageously, the adaptive notch filter further comprises a further low-pass filter for receiving the further

output sequence of $z_0$ and for providing the further signal to the interference detection control unit. Hence, the stability of each deactivation regime of each further filter stage may be enhanced.

In a further preferred embodiment the interference detection control unit is configured to apply the further deactivation criterion independently from the deactivation criterion. Thus, each filter stage may independently be activated or deactivated, thereby providing enhanced flexibility in responding to variations of signal strength of the interferers.

According to a further aspect of the present invention a receiver comprises a front-end section configured to receive an analog radio frequency signal and to output a down-converted digital signal and an adaptive notch filter according to any of the embodiments described above and described in the following description. The adaptive notch filter is connected to receive the down-converted digital signal, and is further configured to selectively output the down-converted digital signal or a filtered version thereof. Moreover, the receiver comprises a signal processing unit connected to receive an output signal of the adaptive notch filter.

Hence, an efficient receiver unit is provided, which can efficiently be used for GPS applications due to its superior capabilities to detect and track CW interferers.

In some illustrative embodiments, the receiver may include a plurality of notch filter stages with internal interference detection capabilities as described above, thereby providing high-performance receivers at low cost due to the efficient detection regime of each of the plurality of filter stages.

In a further aspect, the present invention relates to a method for reducing an interference signal by a notch filter. The method comprises adapting a complex zero and the complex conjugate thereof of a two-pole notch filter stage to isolate a real frequency component of the interference signal in a digital input signal, determining a convergence behaviour of the complex zero of the two-pole notch filter stage, and using a deactivation criterion based on the convergence behaviour of the complex zero to selectively use the digital input signal or a filtered signal obtained from the two-pole notch stage for a further signal processing.

As previously explained, effective interference tracking and interference detection may be performed on the basis of the filter output itself. Hence, less complex computational resources may be required, while enhanced interference rejection and reduced performance loss in the absence of a pronounced interferer may be achieved.

In further embodiments the following features may be provided. The convergence behaviour may be determined on the basis of a magnitude of said complex zero, wherein in illustrative embodiments the deactivation criterion is established by determining a threshold value for the magnitude of the complex zero. An estimation of the magnitude of complex zero may comprise the averaging of the output sequence of $z_0$ and the estimation of the magnitude on the basis of the averaged sequence of $z_0$. In one embodiment averaging the sequence of $z_0$ comprises performing a low-pass filtering process. Preferably, adapting the complex zeros comprises compensating the effect of the two complex zeros by using two poles having the same phase compared to the complex zeros. In one embodiment the modulus of the two poles is contracted by a predefined factor compared to the modulus of the complex zeros.

In one illustrative embodiment the zeros are adapted by determining a minimum output power of the filtered signal. In this way effective techniques using the least mean square algorithm may be used, thereby providing an efficient technique for tracking and detecting, a corresponding interference component.

In a further illustrative embodiment a plurality of interferers may be rejected on the basis of a plurality of two-pole notch filter stages, wherein each stage may individually be activated or deactivated on the basis of the corresponding filter output, as is also described above.

Further objects, advantages and embodiments are described in the following detailed description and in the appended claims. The following detailed description may be understood more fully when referring to the accompanying drawings, in which:

Fig. 1 a schematically depicts a transfer function of a single-pole notch filter;

Fig. 1 b schematically illustrates a diagram of an adaptive filter unit;

Figs 2a to 2c schematically illustrate a notch filter stage used for determining filter characteristics;

Figs 2d to 2o schematically depict spectra and simulation results according to the present invention;

Figs 2p, 2q schematically depict a two-pole notch filter stage according to the present invention;

Figs 2r to 2x schematically illustrate respective simulation results for the two-pole filter stage;

Figs 3a, 3b illustrate the convergence behaviour of the zeros of the two-pole filter stage;

Fig 3c depicts adjustment of a deactivation criterion according to one illustrative embodiment;

Figs 3d, 3e schematically illustrate a filter stage connected to a detection control unit using the filter output for detecting the presence of an interferer;

Fig 3f schematically illustrates the detection probability for different conditions; and

Fig 3g schematically illustrates a multi-pole filter system with autonomous detection of multiple interferers according to one illustrative embodiment.

The present invention relates to a two-pole notch filter and a multi-pole notch filter and in particular addresses the problem of automatic interference detection. In this respect an innovative interference detection strategy is provided that is coupled with one or more two-pole notch filter stages employed for mitigation. For example the problem of the interfering detection is usually not addressed and the CW presence is often assumed or accepted in conventional techniques. The presence of more than one CW is rarely considered and the analysis is often limited to one complex interfering signal.

In the present invention the presence of one or more real interfering frequencies may be taken into consideration. At first the case of a single real interferer may be considered. This kind of signal presents two spectral lines in correspondence of the frequencies $f_i$ and $-f_i$, and thus two zeros are necessary to mitigate its impact. The basic element of the multi-notch filter is thus the two-pole notch filter that is characterized by two complex conjugate zeros, $z_0$ and $z_0^*$, that are continuously adapted in order to track the real CW. The impact of the two zeros on the useful signal is partially compensated by the presence of two complex conjugate poles that have the same phase of $z_0$ and $z_0^*$, and the modulus is contracted by a factor $k_a$, the pole contraction factor, that regulates the notch bandwidth.
In a preferred embodiment the zeros are progressively adapted by a LMS (least means square) algorithm that minimizes the notch filter output power. In fact the CW is expected to carry high power concentrated at the frequencies $f_i$ and $-f_i$ and the minimization of the output power is obtained when two deep notches are placed in correspondence of those frequencies. Thus the minimization of the output power involves the interfering cancellation.

As previously explained, it appears that, when the interferer is not present, the two-pole notch filter can introduce a relevant degradation in the signal so that it should be deactivated, that is, bypassed. Thus the present invention provides a detection algorithm that may be coupled with the two-pole notch filter. The proposed detection criterion is simple and requires a very low computational load. The detection unit is essentially based on the convergence properties of $z_0$. In this way the two-pole notch filter is able to autonomously detect the interfering presence and to decide its activation and deactivation.

The multi-pole notch filter is obtained by cascading two or more two-pole notch filters. When more than one CW interferer is present, the first two-pole notch filter in the chain mitigates the most powerful disturbing signal, whereas the other filters remove the other interferers with progressively decreasing power. The detection units coupled with each notch filter in the chain allow to activate only a number of filters equal to the number of interfering signals thus minimizing the loss on the useful signal.

First a short introduction on the notch filter structure on the basis of a single pole notch filter is provided to facilitate the understanding of the present invention.

Calmettes and al. analyzed a single pole notch filter as potential method for complex interference mitigation. This kind of filter is proposed as starting point for the design of more complex mitigation units. In this section the structure of the filter proposed by Calmettes et al is reported and an LMS algorithm is derived. The one-pole filter was designed by Calmettes for filtering a complex sinusoidal interfering like

$$i[n] = A \exp(j2\pi f_i^a n T_s + \phi_i) \qquad (A)$$

where:

- n is the discrete-time;
- A is the amplitude of the complex sinusoid;
- $f_i^a$ and $\phi_i$ are the analog frequency and the phase of the interference;
- $T_s$ is the sampling interval.

The filter and all the systems referred to in the following are digital devices and therefore they are supposed to deal with digital signals. All the input analog signals are digitally converted with a sampling frequency $f_s = 1/T_s$ and for this reason also the interference of the equation above (A) results in a sampled version. For simplicity the dependence on the sampling interval $T_s$ will be omitted and the analog frequencies are substituted by their digital equivalent; the interference frequency then becomes:

$$f_i = f_i^a T_s = f_i^a / f_s$$

Considering equation (A) is easy to notice that the interference corresponds to only one point on the unit circle of the z plane: only one zero ($z = z_0$) is required to mitigate the interfering spectral line corresponding to the $f_i$ frequency. At the same time a pole in $z = k_a z_0$ is required to compensate the effects of the zero, while the parameter $k_a$ allows the regulation of the notch bandwidth. For stability reasons $k_a < I$. So, the transfer function of the filter is given by

$$H(z) = \frac{1 - z_0 z^{-1}}{1 - z_0 k_a z^{-1}}$$

Fig. 2a schematically shows the structure of the filter 200 comprising an autoregressive (AR) block 230, a moving average (MA) block 210, an adaptive block 220 and a reaction block 240. The input signal z[n] is the input signal composed by white gaussian noise, the GPS/Galileo signal and a complex interferer:

$$z[n] = \eta[n] + c[n] + A \exp\{2j\pi f_i n + \dot{\varphi}_i\}$$

z[n] is obtained by down-converting and digitalizing the received analog signal. For this analysis the contribution of the GPS/Galileo signal will be neglected for its weakness z[n] is filtered by an ARMA (Autoregressive Moving Average) structure composed by three blocks 210, ..., 230, the AR (Autoregressive) 230, the MA (Moving Average) 210 and the adaptive block 220. The MA transfer function is given by:

$$H_{MA}(z) = (1 - z_0 z^{-1})$$

The AR block 230 aims to compensate the effects of the MA block 210 outside the zero frequency point, so its transfer function is given by

$$H_{AR}(z) = \frac{1}{(1 - k_a z_0 z^{-1})}$$

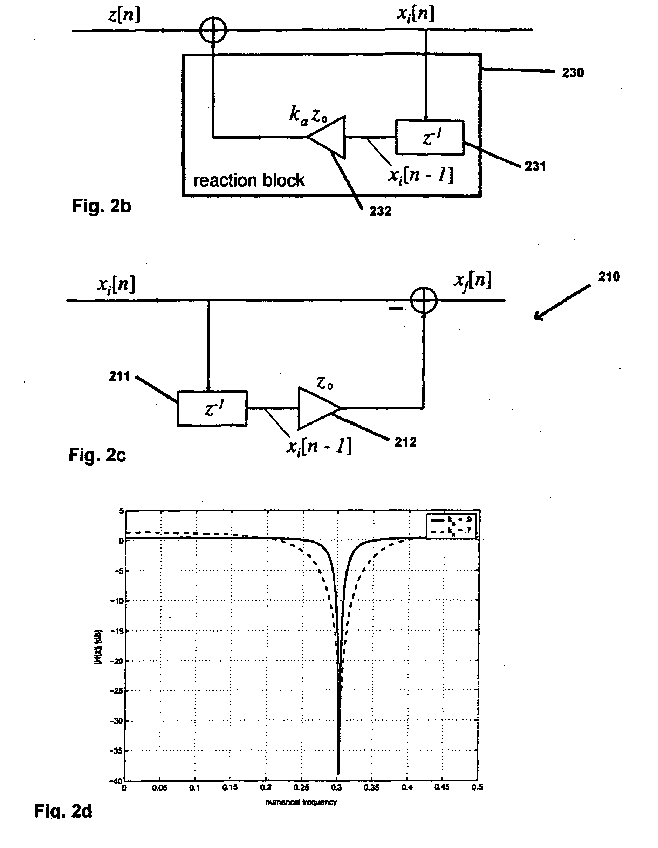

In Figs 2b and 2c the schemes of the AR block 230 and MA block 210 are illustrated. In Fig. 2b the AR block 230 comprises an element 231 that delays the input signal by one sample, while the component 232 is a complex amplifier with gain $k_a z_0$. In Fig. 2c the MA block 210 contains the divider 211 delaying the input by one sample while the component 212 is a complex amplifier with gain $z_0$.

The core of the notch filter 200 is represented by the adaptive block 220 that tracks the interference frequency and adjusts the filter parameters in order to achieve the minimization of a specific cost function. In this section the algorithm used by V. Calmettes et al. is discussed and the adaptive criterion is determined. In particular the only free parameters of the one-pole notch filter 200 are the phase and the absolute value of the zero $z_0$ and they should be continuously adjusted by the adaptive block 220. The adaptive technique chosen by Calmettes is a normalized LMS technique that iteratively minimizes the cost function

$$C = E\{|x_f[n]|^2\}$$

where $x_f[n]$ is the output of the filter. The minimization is performed with respect to the complex parameter $z_0$, using the iterative rule

$$z_0[n+1] = z_0[n] - \mu[n]g(C[n])$$

where g{C[n]} is the stochastic gradient of the cost function C[n]:

$$g(C[n]) = \nabla_{z_0}\{|x_f[n]|^2\}$$

and $\mu[n]$ is the algorithm step that is set to

$$\mu[n] = \frac{\delta}{E_{x_i[n]}}$$

$E_{xi[n]}$ is an estimate of $E[|x_i[n]|^2]$ and $\delta$ is the unnormalized LMS algorithm step. $\delta$ controls the convergence properties of the algorithm and it should be accurately chosen in order to guarantee fast convergence and reduced misadjustment. Since $x_f[n]$ is a complex signal and $z_0$ is a complex variable, the complex generalized derivative rules should be used in order to correctly evaluate the stochastic gradient:

$$\nabla f(x) = \frac{\partial f}{\partial \Re e\{x\}} + j\frac{\partial f}{\partial \Im m\{x\}} = 2\frac{\partial f}{\partial x^*}$$

where * indicates the complex conjugate. Further details on the complex generalized derivative rules can be found in S. Haykin, "Adaptive Filter Theory", Prentice Hall;4th edition, September 2001.

Using this definition it is possible to compute

$$g(C[n]) = \nabla_{z_0}\{|x_f[n]|^2\} = 2\frac{\partial|x_f[n]|^2}{\partial z_0^*} = 2\frac{\partial|x_f[n]|^2}{\partial x_f^*}\frac{\partial x_f^*[n]}{\partial z_0^*} =$$
$$= 2x_f[n]\nabla_{z_0}\{x_i^*[n] - z_0^*x_i^*[n-1]\}$$
$$= 4x_f[n](-x_i^*[n-1])$$

This LMS algorithm, (according to the above expression), has been implemented and tested in MATLAB proving the efficiency of the system.

Fig. 2d illustrates an example of the transfer function of the implemented notch filter for $k_a$ = 0.9 and $k_a$ = 0.7. A sinusoid in noise with an Interference to Noise ratio J/N of 6 dB is isolated and cancelled by the frequency response of the filter. The transfer function is obtained in steady state conditions. It can be seen that the width of the rejection band is regulated by the factor $k_a$: the more $k_a$ is close to 1 the more the rejection band is narrow, however values of $k_a$ too dose to 1 cannot be employed for stability and convergence reasons.

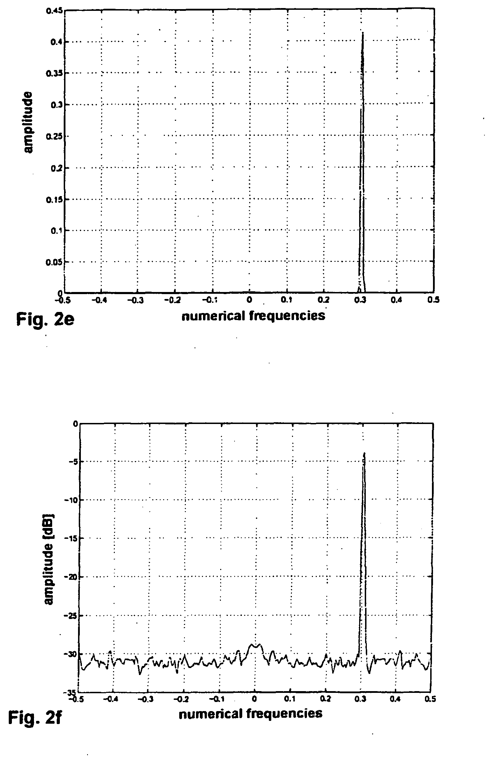

Fig. 2e shows the normalized spectrum of the input signal. The noise is not visible since its power is spread over the frequencies, while the interferer power is concentrated in the $f_i$ frequency. The J/N ratio = 6 dB.

Fig. 2f shows the signal in a logarithmic scale.

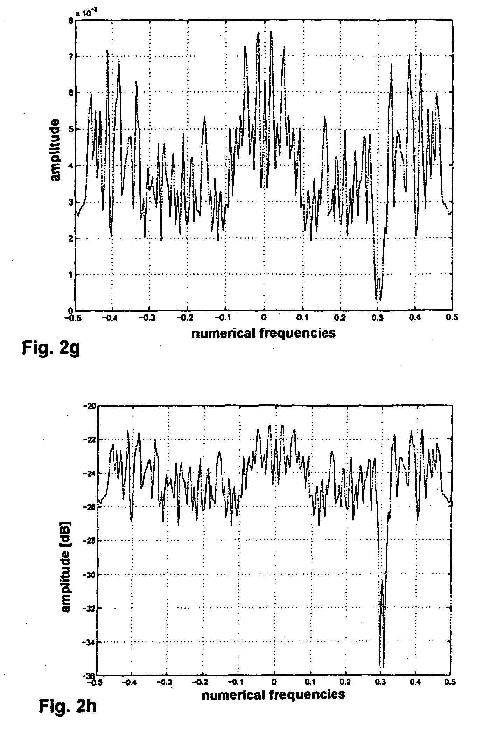

Fig. 2g illustrates the normalized spectrum of the filtered output signal.

Fig. 2h illustrates the normalized spectrum of the filtered output signal in a logarithmic scale.

In Figs 2e, 2f and 2g, 2h the spectrum of the noisy input signal and the output filtered signal are reported. It can be noticed how the interference peak has been eliminated.

The performances of the filter have been tested by imposing the amplitude and phase of the interfering and monitoring outputs, such as the filter transfer function, the position of the zeros, etc. Some simulation results will be illustrated in the following.

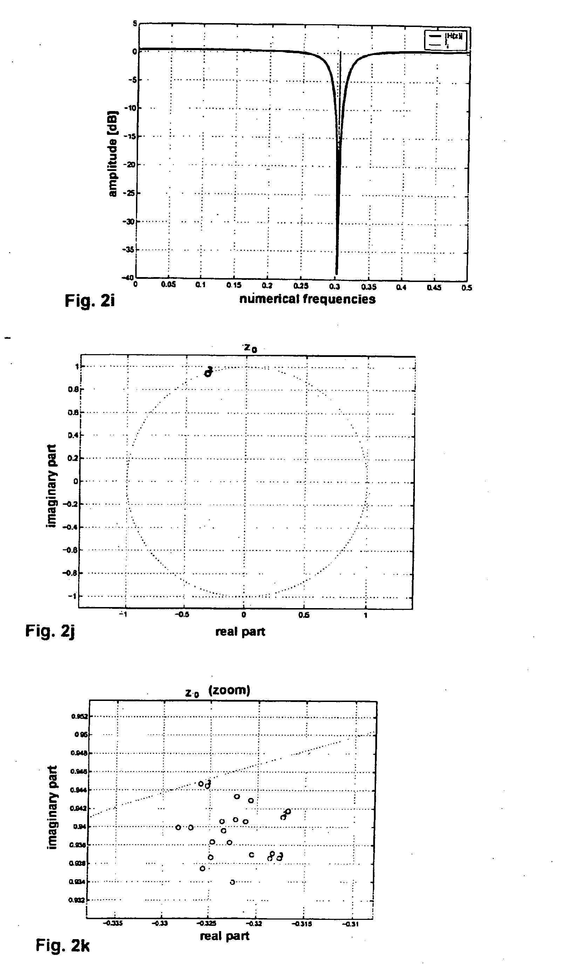

Fig 2i shows the transfer function of the filter for $k_a$ = 0.9 and $\delta$ = 0.07, together with the line indicating the interfering frequency $f_i$, thereby indicating that the filter has correctly individuated the sinusoid.

In Fig. 2j the sequence of zeros calculated by the iterative LMS for $k_a$ = 0.9 and $\delta$ = 0.07 are represented in the z-plane, proving the convergence of the algorithm.

Fig 2k shows a zoom of Fig. 2j.

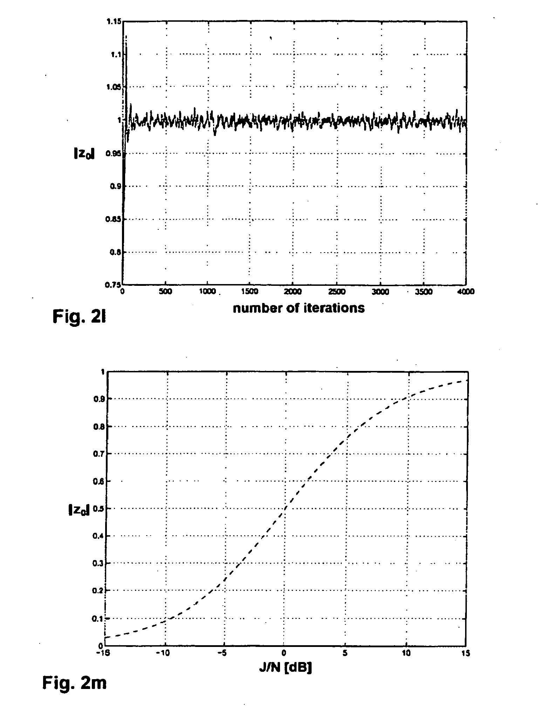

Fig 2l shows how the modulus of $z_0$ settles around one: this may be considered as another confirmation of the convergence of the algorithm.

All these figures have been obtained in steady state condition, and with an amplitude A = 10, J/N = 6dB, $k_a$ = 0.9 and $\delta$ = 0.07.

The LMS can not exactly find the optimal $z_0$ that minimizes the cost function C, for the intrinsic nature of the algorithm and for a residual misadjustment due to the algorithm step ($\mu[n]$) of the method, $z_0$ that exactly minimizes C is called Wiener solution. In general it is not easy to evaluate it, either because in a real context the expectation present in the cost function requires a delicate estimation process and because the relevant computational load does usually not allow real time applications. In some cases, however, it is possible to theoretically evaluate the Wiener solution. According to the present invention the asymptotical performances of the LMS algorithm are studied; in fact it is possible to show that in steady state conditions the LMS solution tends to the Wiener solution. It is therefore possible to obtain useful information on this adaptive algorithm behaviour.

Calmettes et al propose an approximate Wiener solution for the one-pole notch filter.

Fig 2m shows the corresponding progression of the modulus of $z_0$. That solution is independent from $k_a$, but simulation results prove that this does not correspond to the real case.

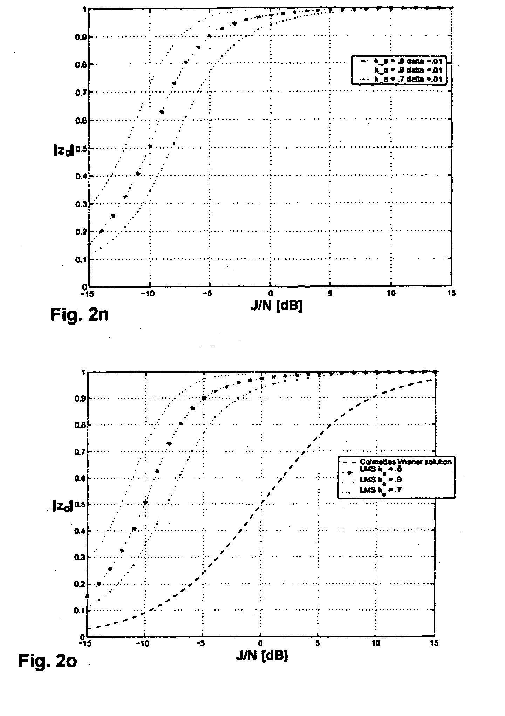

Fig 2n shows corresponding results. As shown the modulus of the $z_0$ is represented as a function of the J/N ratio. An interfering to noise ratio J/N has been obtained varying in the range (-15 dB, 15 dB), the total power of the signal has been kept constant and $k_a$ has been set to 0.7, 0.8 and 0.9.

Fig 2o shows the LMS simulations together with the Wiener solution according to Calmettes et al. As is evident a significant deviation from the Wiener solution of Fig 2m is obtained as the simulation results do clearly not match the calculated Wiener solution. The reason is that the Calmettes solution neglects the autoregressive part of the filter 200, so it can be considered as a limit solution for $k_a$ tending to 0.

As described above, the case of a complex sinusoidal interference is extremely interesting for the preliminary analysis but with limited applicability. According to the present invention a first step in its generalization is provided by extending the filter design to real sinusoids. This means that now two spectral lines have to be mitigated, thus requiring two zeros in the transfer function. The structure of the two-poles notch filter is similar to the one described for the one-pole filter: an AR MA structure comprising three blocks, the AR 230, the MA 210 and the adaptive unit 220 (see Fig 2a).

The filter 200 is designed for filtering the real sinusoidal interference:

$$i[n] = A\cos(2\pi f_i^a nT_s + \phi_i)$$

where:

- A is the interfering signal amplitude;
- $f_i^a$ and $\phi_i$ the analog frequency and the phase of the continuous wave;
- $T_s$ the sampling interval;
- n the time index.

The MA transfer function is then given by

$$H_{MA}(z) = (1 - z_0 z^{-1})(1 - z_0^* z^{-1}) = 1 - 2\mathbb{R}e\{z_0\}z^{-1} + |z_0|^2 z^{-2}$$

The AR block 230 is constrained to compensate the effects of the MA block 210 with respect to the frequencies other than the zeros' frequencies and its transfer function is given by:

$$H_{AR}(z) = \frac{1}{(1 - k_\alpha z_0 z^{-1})(1 - k_\alpha z_0^* z^{-1})} = \frac{1}{1 - 2k_\alpha \mathbb{R}e\{z_0\}z^{-1} + k_\alpha^2 |z_0|^2 z^{-2}}$$

In this way the transfer function of the whole filter is

$$H(z) = \frac{1 - 2Re\{z_0\}z^{-1} + |z_0|^2 \ z^{-2}}{1 - 2k_a Re\{z_0\}z^{-1} + k_a^2 |z_0|^2 \ z^{-2}} \ .$$

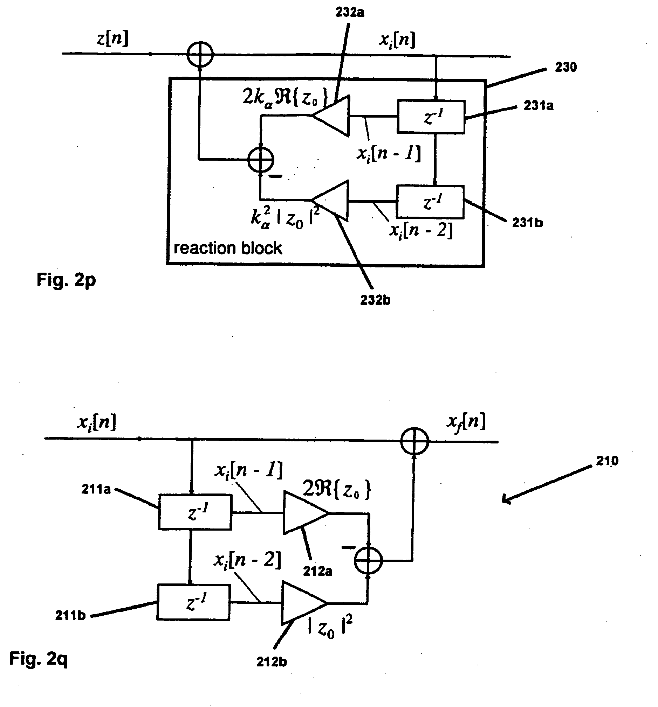

In Figs 2p and 2q the schemes of the AR and MA blocks 230 and 210 are illustrated.

In the AR block 230 two dividers 231 a and 231 b each provide a delay of one sample, whereas the amplifiers 232a, 232b have a gain corresponding to the respective transfer function described above. Similarly, the dividers 211 a, 211 b in the MA block 210 provide a delay of one sample, whereas the amplifiers 212a, 212b have a gain as specified above for the transfer function of the MA block 210.

For the adaptive block 220 the same LMS algorithm used for the complex case and based on the minimization of the cost function $E\{|x_f(n)|^2\}$ with respect to the complex parameter $z_0$ has been adopted. In this case the expression of the stochastic gradient is given by:

$$g(C[n]) = 4x_f[n](z_0 x_i[n-2] - x_i[n-1])$$

This LMS algorithm according to this cost function has been implemented and tested in MATLAB proving the efficiency of the system.

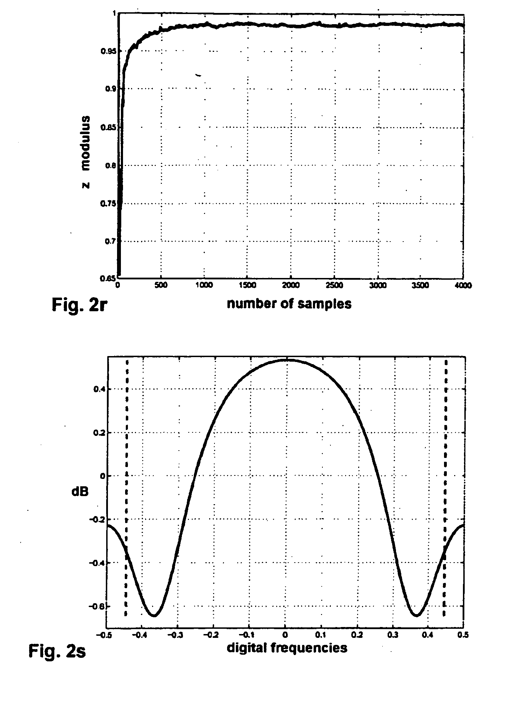

Fig 2r shows the convergence of the adapted parameter $z_0$ where the magnitude or modulus of the adjusted parameter $z_0$ is depicted. The magnitude or modulus of $z_0$ converges to a value close to 1 that results in two zeros in the transfer function of the filter corresponding to the frequencies $\pm f_i$.

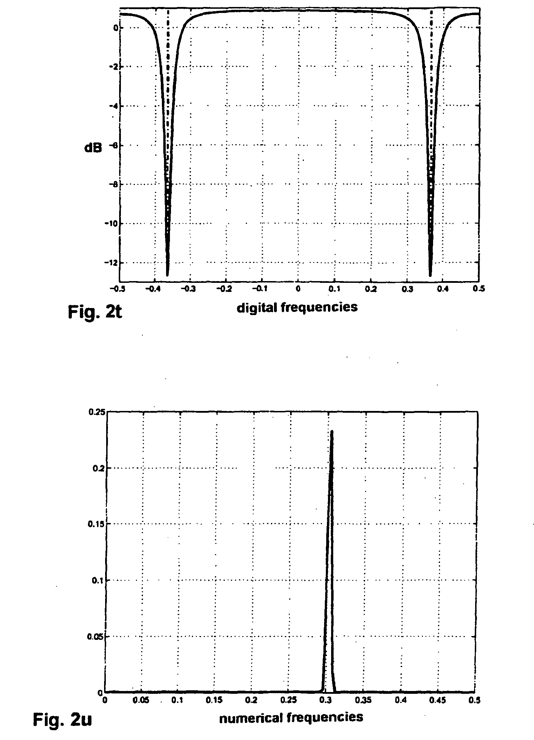

In Figs 2s and 2t two examples of transfer functions of the implemented notch filter 200 are depicted. In Fig 2s transfer function of the notch filter 200 for $k_a = 0.9$ at transient conditions is illustrated, $z_0$ has not converged yet to the value allowing the interference mitigation.

In Fig 2t the system has reached the steady state conditions and the interfering sinusoid is isolated and cancelled by the frequency response of the filter 200.

Both transfer functions have been obtained with an Interference to Noise ratio J/N of 0 dB. In order to show the effectiveness of the two-pole system 200

in Figs 2u to 2x the spectra of the input and output signals of the notch filter 200 are illustrated.

Fig 2u shows the normalized onesided PSD of the input signal for J/N = 6 dB.

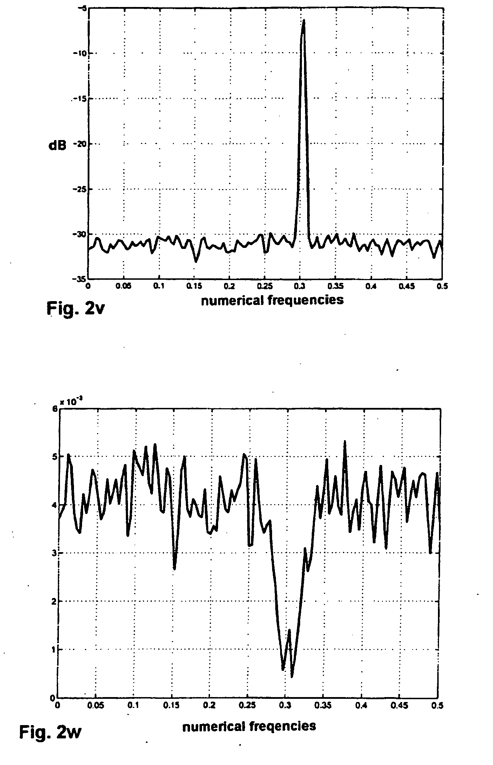

Fig 2v shows the normalized onesided PSD of the input signal for J/N = 6 dB in logarithmic scale.

Fig 2w shows the normalized onesided PSD of the output signal for J/N = 6 dB.

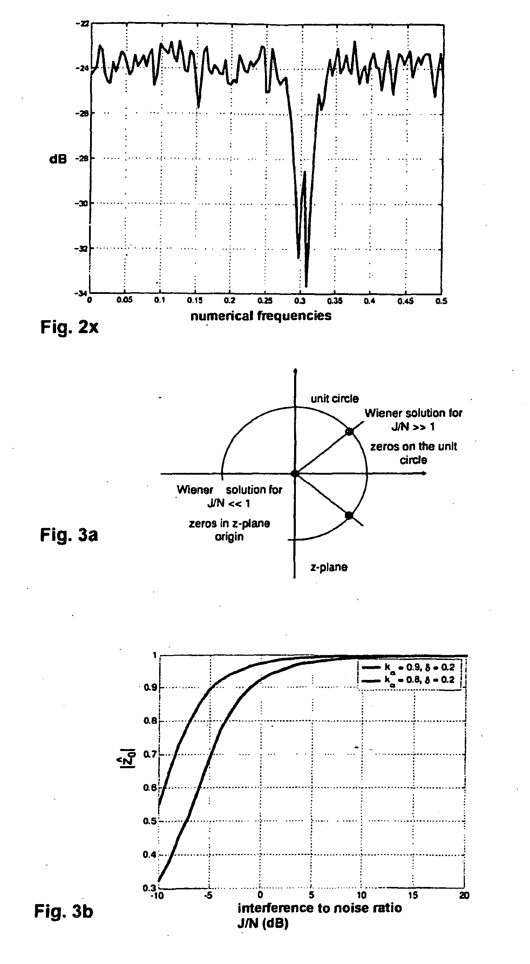

Fig 2x shows normalized onesided PSD of the output signal for J/N = 6 dB in a logarithmic scale. As is evident, the system works properly and the output signal results whitened.

Having an efficient notch filter that attenuates specific frequencies may not be enough for an efficient interference mitigation. In fact the presence or absence of the interference is also an important aspect. An efficient filtering mechanism has not to deteriorate the signal when the interference is absent. It can been proved that leaving the notch filter active in absence of interference introduces some losses in performance. In other terms, in order to be effectively implemented, a notch filter may require an interference detection technique. The technique of the present invention is very efficient in computational terms. Since the magnitude or modulus of the complex parameter $z_0$ is not constrained to 1 (as in many other different works), it is possible to use the modulus as indicator of the filter state. The Wiener solution for $z_0$ is not easily computable, however it is possible to determine the two extreme conditions that are verified either when the white noise component is absent or when the sinusoidal interference is not present. The Wiener solution is the one that solves the equation:

$$E\{g(C[n])\} = \nabla C[n] = 0$$

when the noise is absent, and considering the sinusoidal interference as a deterministic signal, it is possible to remove the expected value operator and the above equation degenerates into:

$$x_f[n](z_0 x_i[n-2] - x_i[n-1]) = 0$$

that implies that $x_f[n]$ has to be zero for all n. Since the input signal is a sinusoid and the notch filter has a real impulse response

$$x_i[n] = \left| H\left(e^{j2\pi f_i}\right) \right| A\cos(2\pi f_i n + \phi_i + \phi_h)$$

where $\phi_h$ is the phase of the transfer function of the notch filter in correspondence to the interference frequency $f_i$. In order to have $x_f[n] = 0$ for all n, it is necessary to have:

$$\left| H\left(e^{\pm j2\pi f_i}\right) \right| = 0$$

that implies $z_0 = e^{j2\pi fi}$.

Under the hypothesis of absence of interference but presence of white noise, the condition of minimum $E[x_f[n]]$ corresponds to the minimization of the energy of h[n] which is the impulse response of the notch filter:

$$z_0^{opt} = \arg\min E\{|x_f[n]|^2\} = \arg\min \sum_{i=0}^{+\infty} h^2[n]$$

$$= \arg\min \int_{-0.5}^{0.5} \left| H\left(e^{j2\pi f_i}\right) \right|^2 df$$

$$= \arg\min \frac{1}{2\pi j} \oint_C H(z)H(z^{-1})z^{-1}dz$$

This minimum condition is verified for $z_0 = 0$. From these considerations it appears that the modulus of $z_0$ varies continuously between 0 and 1 depending on the Interference to Noise Ratio.

Fig 3a schematically illustrates this situation for the two extreme situations. The zero positions for the two poles Wiener solution in extreme conditions for the J/N.

Fig 3b illustrates the mean magnitude of $z_0$ for $k_a = 0.9$ and $k_a = 0.8$.

These curves have been obtained by simulation, imposing a randomly chosen CW frequency which varied iteration after iteration, and thus leading to an average performance. The magnitude of the mean $z_0$, which is a filtered version of $z_0$, can be used for detection purposes: if its absolute value is greater than a pre-assigned threshold the system decides that a sinusoidal interference is present and the notch filter should be activated, that is, the filter output should be used for further signal processing, otherwise the interference is considered absent or with a negligible power and the notch filter should be deactivated, i.e, the input signal should be used for the further signal processing. Curves like the one illustrated in Fig 3b can be used in order to set the threshold: once defined under what level L of Interference to Noise Ratio an interference can be considered negligible, which may be determined by an a priori analysis, the threshold T is fixed at the $z_0$ (ordinate axis) corresponding to L (abscissa axis) over the curve related to specific $k_a$.

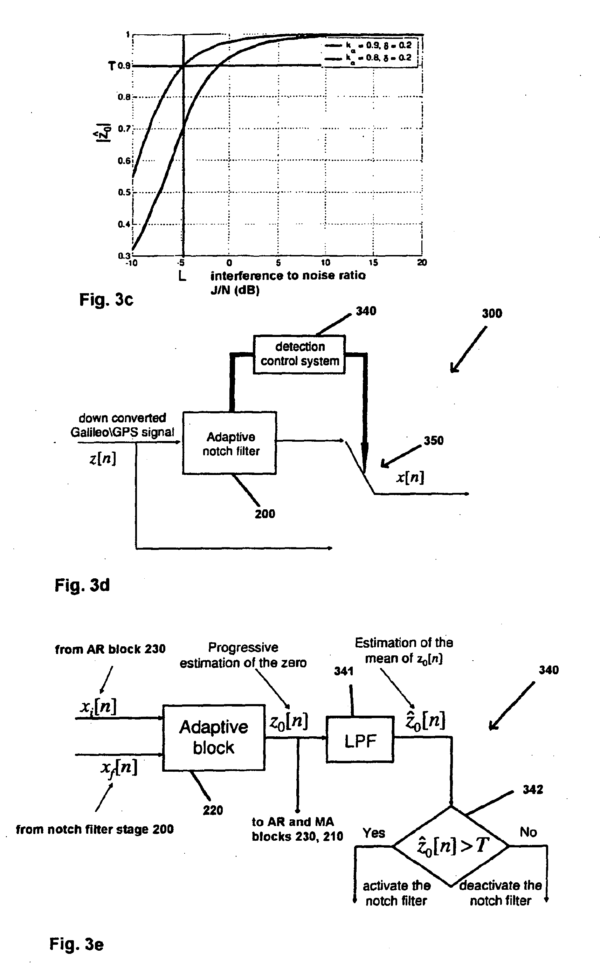

Fig 3c depicts an example for setting an appropriate threshold as a means for using the convergence behaviour of the zeros for estimating the presence or absence of the interference signal.

Fig 3d schematically illustrates the overall structure of an autonomous detection notch filter system 300 according to one illustrative embodiment. The system 300 comprises a two-pole notch filter stage 200, as described above. Furthermore, a detection control unit 340 is connected to the filter stage 200 so that the correct output signal is selected. The detection control unit is coupled to a switching element 350 that is configured to bypass the filter stage 200, when correspondingly instructed by the detection control unit 340.

During operation of the system 300 the down-converted digitalized signal enters the notch filter stage 200 that tries to mitigate a possible sinusoidal interference: if the test on the adapted parameter $z_0$, that is, for instance by setting a threshold in advance as shown in Fig 3c and comparing the modulus of $z_0$ with the pre-established threshold, is passed, the control detection unit 340 drives the switching unit 350 to provide the filtered signal to feed the acquisition block, otherwise the filter stage 200 is bypassed and the original signal is used for the further signal processing.

In Fig 3e the detection control unit 340 is illustrated in more detail according to one illustrative embodiment. In this example the detection control unit comprises a low-pass filter 341 and a deactivation criterion 342, provided in the form of a decision block.

During operation, the adaptive block is continuously fed by the AR block 230 and notch filter stage 200 and it produces at every instant n an estimation of the zero $z_0[n]$. As explained before, the activation of the notch filter 200 should depend on $z_0[n]$: if it passes the threshold T the notch filter 200 should be activated, otherwise deactivated. However the sequence $z_0[n]$ can be considered as a random process with a certain variance. Consequently, the presence of oscillations could cause continuous passing from the active to the inactive state. For this reason the low-pass filter 341 has been added in order to reduce the variance of $z_0[n]$, thereby producing a new signal $z_0[n]$, which is used for deciding whether or not to bypass the filter stage 200.

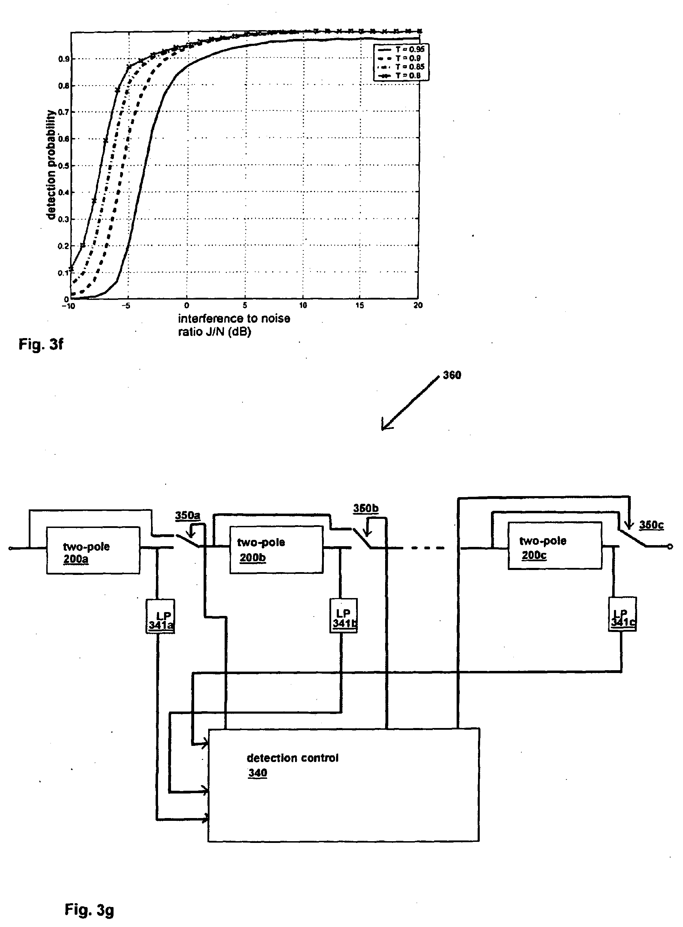

Fig 3f shows the probability of the system 300, evaluated by simulation, of detecting a sinusoidal interference with $k_a = 0.9$ with respect to the interference to noise ratio and for different threshold values. It can be seen that a lower threshold corresponds to a higher detection capability. However a high detection capability implies also high false alarm probability. Moreover a low threshold can lead to the activation of the notch filter 200 even in presence of low power or absent interference.

As is explained above, a highly efficient detection regime may be provided on the basis of the output sequence of $z_0$ of the two-pole filter stage itself, while using a deactivation criterion that may be derived from the modulus of the zeros. It should be appreciated that the mitigation of a plurality of interfering frequencies may be accomplished by providing a plurality of filter stages, such as the filter stage 200, wherein each filter stage may have its associated detection control unit, such as the unit 340 in order to decide whether or not the respective filter stage is to be bypassed, i.e., the absence of the respective interfering frequency is detected or not. Thus, by cascading a plurality of systems 300, multiple interferers may be tracked and detected.

Fig 3g schematically illustrates a multi-pole notch filter system 360, in which a detection control 340 is connected to a plurality of filter stages 200a, ..., 200c, which may be configured as previously described. The detection control unit 340 may control on the basis of individual deactivation criteria respective switches 350a, ... , 350c in order to individually bypass the associated filter stages 200a, ... , 200c when the respective criterion indicates that the respective interfering signal is absent. Thus, interfering signal frequencies may be suppressed, wherein the number of interfering signals may be equal to the number of active filter stages, while non-required stages may be bypassed, thereby minimizing any performance losses. Hence, the system 360 may adapt itself in an autonomous manner to the number of interferers as well to their precise frequencies.

As a result, when no interference is present the notch filter 200 may not cause a loss in performances, since a mechanism is provided to know when to activate and deactivate the filter 200. The detection of the interference is an autodetection: it is the notch filter itself that tells if its use is convenient or not, thus requiring very few resources. This technique is substantially based on the monitoring of the absolute value of the zero and this is possible because that modulus is not constrained to one, differently from most of conventional techniques related to notches. This method has proven to be both efficient and fast.

**Claims**

1. An adaptive notch filter system (300) comprising :

   a two-pole notch filter stage (200) connected to receive a digital input signal z[n] comprising an interference signal, and to output a filtered digital output signal x[n] and a sequence $z_0[n]$ representing an estimation of a complex zero $z_0$ of said two-pole notch filter stage (200) at every instant n,
   said two-pole notch filter stage (200) further comprising an adaptive unit (220) configured to adjust said complex zero on the bases of a real frequency component of the interference signal, and
   an interference detection control unit (340) connected to said two pole notch filter stage (200) to receive said sequence $z_0[n]$, said interference detection control unit (340) configured to apply a deactivation criterion (342,T) based on a convergence behaviour of said sequence $z_0[n]$ representing an estimation of said complex zero $z_0$ at every instant n for bypassing said two-pole notch filter stage when said deactivation criterion (342,T) is met.

2. An adaptive notch filter system according to claim 1, wherein said deactivation criterion (342, T) is represented by the passing of a threshold by the magnitudes of the complex zeros.

3. An adaptive notch filter system according to claim 1 or 2, further comprising a low pass filter stage (341) connected to receive said sequence $z_0$ [n] and to provide said signal to said interference detection control unit.

4. An adaptive notch filter system according to any of claims 1 to 3, wherein said two-pole filter stage comprises a moving average block (210) for suppressing said real frequency component of said interference signal, and an autoregressive block (230) for compensating suppression of frequency components other than said real frequency component.

5. An adaptive notch filter system according to claim 4, wherein said moving average block (230) is defined by a first transfer function including the real part of said zero and the square of said zero, and wherein said autoregressive block (230) is defined by a second transfer function corresponding to an inverse of said first transfer function including a weighting factor for said complex zero.

6. An adaptive notch filter system according to claim 5, wherein said first transfer function is implemented as a first divider including a first delay stage coupled to a first multiplier, and a second divider connected to said first divider and including a second delay stage, said second divider being coupled to a second multiplier.

7. An adaptive notch filter system according to claim 6, wherein said first multiplier multiplies by two times the real part of the complex zero, and said second multiplier multiplies by the square of the magnitude of the complex zero.

8. An adaptive notch filter system according to any of claims 1 to 7, further comprising at least one further two-pole notch filter stage (200b, 200c) connected to receive said output signal as input and to output a further output signal filtered at least twice, said further two-pole notch filter stage (200b, 200c) further comprising an adaptive unit, wherein said adaptive unit of said further two-pole notch filter stage (200b, 200c) is configured to adjust a phase and a magnitude of a further zero of said at least one further two-pole notch filter stage corresponding to a further real frequency component of said interference signal, said further real frequency component differing from said real frequency component,
and wherein said interference detection control unit is connected to receive a further signal corresponding to said further sequence $z_0$ [n], said interference detection control unit configured to apply a further deactivation criterion based on a convergence behaviour of said further sequence $z_0$ [n] of said further zero of said at least one further two-pole filter stage for bypassing said at least one further two-pole filter stage (200b, 200c) when said further deactivation criterion is met.

9. An adaptive notch filter according to claim 8, further comprising a further low-pass filter (341 b, 341 c) for receiving said further sequence $z_0$ [n] and for providing said further signal to the interference detection control unit.

10. An adaptive notch filter system according to claim 8 or 9, wherein said interference detection control unit is configured to apply said further deactivation criterion independently from said deactivation criterion.

11. A receiver comprising:

a front-end section configured to receive an analog radio frequency signal and to output a down-converted digital signal; and
an adaptive notch filter system according to any of claims 1 to 10 and connected to receive said down-converted digital signal, said adaptive notch filter configured to selectively output said down-converted digital signal or a filtered version thereof, and
a signal processing unit connected to receive an output signal of said adaptive notch filter.

12. The receiver of claim 11, wherein said analog radio frequency signal is a signal of a global positioning system.

13. A method for reducing an interference signal by a notch filter, the method comprising:

adapting a complex zero and the complex conjugate thereof of a two-pole notch filter stage (300) to isolate a real frequency component of said interference signal in a digital input signal,
determining a convergence behaviour of a sequence $z_0$ [n] representing an estimation of a complex zero of the two-pole notch filter stage at every instant n, and
using a deactivation criterion based on said convergence behaviour of the complex zero to selectively bypass said two-pole filter stage.

14. The method of claim 13, wherein determining said convergence behaviour comprises estimating a modulus of said complex zeros.

15. The method of claim 14, wherein said deactivation criterion is established by determining a threshold value for the modulus of said complex zeros.

16. The method of claim 14 or 15, wherein estimating the modulus of complex zeros comprises averaging said sequence of $z_0$

17. The method of claim 16, wherein averaging said sequence of $z_0$ comprises performing a low-pass filtering process.

18. The method of any of claims 13 to 17, wherein adapting said complex zeros comprises compensating the effect of the two complex zeros by using two poles having the same phase compared to the complex zeros.

19. The method of claim 18, wherein a modulus of the two poles is contracted by a predefined factor compared to the modulus of the complex zeros.

20. The method of any of claims 13 to 19, wherein said zeros are adapted by determining a minimum output power of said filtered signal.

21. The method of any of claims 13 to 20, further comprising entering said filtered signal into at least one further two-pole notch filter stage and adapting an at least one further zero and a complex conjugate thereof to at least one further real frequency component of said interference signal for providing at least one further filtered output signal.

22. The method of claim 21, further comprising determining a convergence behaviour of a modulus of said at least one further zero and using said determined convergence behaviour for selecting said at least one further filtered output signal or said filtered output signal entered into said at least one further two-pole notch filter stage for further signal processing.

**Patentansprüche**

1. Adaptives Kerbfiltersystem (300), das umfasst:

   eine Zweipol-Kerbfilterstufe (200), die so verbunden ist, dass sie ein digitales Eingangssignal z[n] empfängt, das ein Interferenzsignal umfasst, und ein gefiltertes digitales Ausgangssignal x[n] sowie eine Sequenz $z_0$[n] ausgibt, die einen Schätzwert einer komplexen Null (complex zero) $z_0$ der Zweipol-Kerbfilterstufe (200) in jedem Moment n darstellt,
   wobei die Zweipol-Kerbfilterstufe (200) des Weiteren eine adaptive Einheit (220) umfasst, die so konfiguriert ist, dass sie die komplexe Null auf Basis einer realen Frequenzkomponente des Interferenzsignals anpasst, und eine Interferenzerfassungs-Steuereinheit (340), die mit der Zweipol-Kerbfilterstufe (200) verbunden ist, um die Sequenz $z_0$[n] zu empfangen, wobei die Interferenzerfassungs-Steuereinheit (340) so konfiguriert ist, dass sie ein Deaktivierungs-Kriterium (342,T) auf Basis eines Konvergenzverhaltens der Sequenz $z_0$[n] anwendet, die einen Schätzwert der komplexen Null $z_0$ in jedem Moment n darstellt, um die Zweipol-Kerbfilterstufe zu umgehen, wenn das Deaktivierungs-Kriterium (342,T) erfüllt ist.

2. Adaptives Kerbfiltersystem nach Anspruch 1, wobei das Deaktivierungs-Kriterium (342, T) durch das Über-/Unterschreiten eines Schwellenwertes durch die Werte der komplexen Nullen repräsentiert wird.

3. Adaptives Kerbfiltersystem nach Anspruch 1 oder 2, das des Weiteren eine Tiefpassfilterstufe (341) umfasst, die so verbunden ist, dass sie die Sequenz $z_0$ [n] empfängt und der Interferenzerfassungs-Steuereinheit das Signal bereitstellt.

4. Adaptives Kerbfiltersystem nach einem der Ansprüche 1 bis 3, wobei die Zweipol-Filterstufe einen Gleitmittel-Block (210), mit dem die reale Frequenzkomponente des Interferenzsignals unterdrückt wird, sowie einen Autoregressions-Block (230) umfasst, mit dem Unterdrückung von Frequenzkomponenten mit Ausnahme der realen Frequenzkomponente kompensiert wird.

5. Adaptives Kerbfiltersystem nach Anspruch 4, wobei der Gleitmittel-Block (230) durch eine erste Übertragungsfunktion definiert wird, die den realen Teil der Null und das Quadrat der Null einschließt, und wobei der Autoregressions-Block (230) durch eine zweite Übertragungsfunktion definiert wird, die einem Kehrwert der ersten Übertragungsfunktion einschließlich eines Gewichtungsfaktors für die komplexe Null entspricht.

**6.** Adaptives Kerbfiltersystem nach Anspruch 5, wobei die erste Übertragungsfunktion als eine erste Dividiereinrichtung, die eine erste Verzögerungsstufe enthält, die mit einer ersten Multipliziereinrichtung gekoppelt ist, und eine zweite Dividiereinrichtung implementiert ist, die mit der ersten Dividiereinrichtung verbunden ist und eine zweite Verzögerungsstufe enthält, wobei die zweite Dividiereinrichtung mit einer zweiten Multipliziereinrichtung gekoppelt ist.

**7.** Adaptives Kerbfiltersystem nach Anspruch 6, wobei die erste Multipliziereinrichtung mit dem Zweifachen des realen Teils der komplexen Null multipliziert und die zweite Multipliziereinrichtung mit dem Quadrat des Betrages der komplexen Null multipliziert.

**8.** Adaptives Kerbfiltersystem nach einem der Ansprüche 1 bis 7, das des Weiteren wenigstens eine weitere Zweipol-Kerbfilterstufe (200b, 200c) umfasst, die so verbunden ist, dass sie das Ausgangssignal als Eingang empfängt und ein weiteres Ausgangssignal ausgibt, das wenigstens zweimal gefiltert wird, und wobei die weitere Zweipol-Kerbfilterstufe (200b, 200c) des Weiteren eine adaptive Einheit umfasst,
wobei die adaptive Einheit der weiteren Zweipol-Kerbfilterstufe (200b, 200c) so konfiguriert ist, dass sie eine Phase und einen Wert einer weiteren Null der wenigstens einen weiteren Zweipol-Kerbfilterstufe entsprechend einer weiteren realen Frequenzkomponente des Interferenzsignals anpasst, wobei sich die weitere reale Frequenzkomponente von der realen Frequenzkomponente unterscheidet,
und wobei die Interferenzerfassungs-Steuereinheit so verbunden ist, dass sie ein weiteres Signal empfängt, das der weiteren Sequenz $z_0[n]$ entspricht, und die Interferenzerfassungs-Steuereinheit so konfiguriert ist, dass sie ein weiteres Deaktivierungs-Kriterium auf Basis eines Konvergenzverhaltens der weiteren Sequenz $z_0\{n\}$ der weiteren Null der wenigstens einen weiteren Zweipol-Filterstufe anwendet, um die wenigstens eine weitere Zweipol-Filterstufe (200b, 200c) zu umgehen, wenn das Deaktivierungs-Kriterium erfüllt ist.

**9.** Adaptives Kerbfiltersystem nach Anspruch 8, das des Weiteren ein weiteres Tiefpassfilter (341 b, 341c) umfasst, mit dem die weitere Sequenz $z_0[n]$ empfangen wird und der Interferenzerfassungs-Steuereinheit das weitere Signal bereitgestellt wird.

**10.** Adaptives Kerbfiltersystem nach Anspruch 8 oder 9, wobei die Interferenzerfassungs-Steuereinheit so konfiguriert ist, dass sie das weitere Deaktivierungs-Kriterium unabhängig von dem Deaktivierungs-Kriterium anwendet.

**11.** Empfangsvorrichtung, die umfasst:

einen Front-End-Abschnitt, der so konfiguriert ist, dass er ein analoges Funkfrequenzsignal empfängt und ein Abwärtswandlung unterzogenes digitales Signal ausgibt; und
ein adaptives Kerbfiltersystem nach einem der Ansprüche 1 bis 10, das so verbunden ist, dass es das Abwärtswandlung unterzogene digitale Signal empfängt, wobei das adaptive Kerbfilter so konfiguriert ist, dass es selektiv das Abwärtswandlung unterzogene digitale Signal oder eine gefilterte Version desselben ausgibt; und
eine Signalverarbeitungseinheit, die so verbunden ist, dass sie ein Ausgangssignal des adaptiven Kerbfilters empfängt.

**12.** Empfangsvorrichtung nach Anspruch 11, wobei das analoge Funkfrequenzsignal ein Signal eines globalen Positionierungssystems (GPS) ist.

**13.** Verfahren zum Reduzieren eines Interferenzsignals mittels eines Kerbfilters, wobei das Verfahren umfasst:

Anpassen einer komplexen Null einer Zweipol-Kerbfilterstufe (300) und einer komplex Konjugierten derselben, um eine reale Frequenzkomponente des Interferenzsignals in einem digitalen Eingangssignal zu isolieren,
Bestimmen eines Konvergenzverhaltens einer Sequenz $z_0[n]$, die einen Schätzwert einer komplexen Null der Zweipol-Kerbfilterstufe in jedem Moment n darstellt, und
Verwenden eines Deaktivierungs-Kriteriums auf Basis des Konvergenzverhaltens der komplexen Null, um selektiv die Zweipol-Filterstufe zu umgehen.

**14.** Verfahren nach Anspruch 13, wobei Bestimmen des Konvergenzverhaltens Schätzen eines Modulus der komplexen Nullen umfasst.

**15.** Verfahren nach Anspruch 14, wobei das Deaktivierungs-Kriterium festgelegt wird, indem ein Schwellenwert für den Modulus der komplexen Nullen bestimmt wird.

**16.** Verfahren nach Anspruch 14 oder 15, wobei Schätzen des Modulus der komplexen Nullen Mitteln der Sequenz von $z_0$ umfasst.

**17.** Verfahren nach Anspruch 16, wobei Mitteln der Sequenz von $z_0$ Durchführen eines Tiefpass-Filterungsprozesses umfasst.

**18.** Verfahren nach einem der Ansprüche 13 bis 17, wobei Anpassen der komplexen Nullen Kompensieren des Effekts der zwei komplexen Nullen unter Verwendung von zwei Polen umfasst, die verglichen mit den komplexen Nullen, die gleiche Phase haben.

**19.** Verfahren nach Anspruch 18, wobei ein Modulus der zwei Pole verglichen mit dem Modulus der komplexen Nullen, um einen vordefinierten Faktor kontrahiert ist.

**20.** Verfahren nach einem der Ansprüche 13 bis 19, wobei die Nullen angepasst werden, indem eine minimale Ausgangsleistung des gefilterten Signals bestimmt wird.

**21.** Verfahren nach einem der Ansprüche 13 bis 20, das des Weiteren Eingeben des gefilterten Signals in wenigstens eine weitere Zweipol-Kerbfilterstufe und Anpassen wenigstens einer weiteren Null sowie einer komplex Konjugierten derselben an wenigstens eine weitere reale Frequenzkomponente des Interferenzsignals umfasst, um wenigstens ein weiteres gefiltertes Ausgangssignal bereitzustellen.

**22.** Verfahren nach Anspruch 21, das des Weiteren Bestimmen eines Konvergenzverhaltens eines Modulus der wenigstens einen weiteren Null und Verwenden des bestimmten Konvergenzverhaltens zum Auswählen des wenigstens einen weiteren gefilterten Ausgangssignals oder des gefilterten Ausgangssignals umfasst, das zur weiteren Signalverarbeitung in die wenigstens eine weitere Zweipol-Kerbfilterstufe eingegeben wird.

**Revendications**

**1.** Système de filtre coupe-bande adaptatif (300) comprenant :

un étage de filtre coupe-bande bipolaire (200) connecté de façon à recevoir un signal d'entrée numérique z[n] comprenant un signal d'interférence, et à émettre un signal de sortie numérique filtré x[n] et une séquence $z_0$[n] représentant une estimation d'un zéro complexe $z_0$ dudit étage de filtre coupe-bande bipolaire (200) à chaque instant n,
ledit étage de filtre coupe-bande bipolaire (200) comprenant en outre une unité adaptative (220) conçue pour ajuster ledit zéro complexe sur les bases d'une composante de fréquence réelle du signal d'interférence, et une unité de commande de détection d'interférence (340) connectée audit étage de filtre coupe-bande bipolaire (200) de façon à recevoir ladite séquence $z_0$[n], ladite unité de commande de détection d'interférence (340) étant conçue pour appliquer un critère de désactivation (342, T) sur la base d'un comportement de convergence de ladite séquence $z_0$[n] représentant une estimation dudit zéro complexe $z_0$ à chaque instant n pour contourner ledit étage de filtre coupe-bande bipolaire lorsque le critère de désactivation (342, T) est satisfait.

**2.** Système de filtre coupe-bande adaptatif conformément à la revendication 1, dans lequel ledit critère de désactivation (342, T) est représenté par le passage d'un seuil par les amplitudes des zéros complexes.

**3.** Système de filtre coupe-bande adaptatif conformément à la revendication 1 ou 2 comprenant en outre un étage de filtre passe-bas (341) connecté de façon à recevoir ladite séquence $z_0$[n] et à fournir ledit signal à ladite unité de commande de détection d'interférence.

**4.** Système de filtre coupe-bande adaptatif conformément à l'une quelconque des revendications 1 à 3, dans lequel ledit étage de filtre coupe-bande bipolaire comprend un bloc de moyenne mobile (210) pour supprimer ladite composante de fréquence réelle dudit signal d'interférence, et un bloc autorégressif (230) pour compenser une suppression de composantes de fréquence autres que ladite composante de fréquence réelle.

**5.** Système de filtre coupe-bande adaptatif conformément à la revendication 4, dans lequel ledit bloc de moyenne mobile (230) est défini par une première fonction de transfert comprenant la partie réelle dudit zéro et le carré dudit zéro, et dans lequel ledit bloc autorégressif (230) est défini par une seconde fonction de transfert correspondant à un inverse de ladite première fonction de transfert comprenant un facteur de pondération pour ledit zéro complexe.

6. Système de filtre coupe-bande adaptatif conformément à la revendication 5, dans lequel ladite première fonction de transfert est mise en oeuvre en tant que premier diviseur comprenant un premier étage de retard couplé à un premier multiplicateur, et un second diviseur connecté audit premier diviseur et comprenant un second étage de retard, ledit second diviseur étant couplé à un second multiplicateur.

7. Système de filtre coupe-bande adaptatif conformément à la revendication 6, dans lequel ledit premier multiplicateur multiplie par deux la partie réelle du zéro complexe, et ledit second multiplicateur multiplie par le carré de l'amplitude du zéro complexe.

8. Système de filtre coupe-bande adaptatif conformément à l'une quelconque des revendications 1 à 7, comprenant en outre au moins un autre étage de filtre coupe-bande bipolaire (200b, 200c) connecté de façon à recevoir ledit signal de sortie en tant qu'entrée et émettre un autre signal de sortie filtré au moins deux fois, ledit étage de filtre coupe-bande bipolaire (200b, 200c) comprenant en outre une unité adaptative,
dans lequel ladite unité adaptative dudit autre étage de filtre coupe-bande bipolaire (200b, 200c) est conçue pour ajuster une phase et une amplitude d'un autre zéro dudit autre étage de filtre coupe-bande bipolaire correspondant à une autre composante de fréquence réelle dudit signal d'interférence, ladite autre composante de fréquence réelle étant différente de ladite composante de fréquence réelle,
et dans lequel ladite unité de commande de détection d'interférence est connectée pour recevoir un autre signal correspondant à ladite autre séquence $z_0[n]$ , ladite unité de commande de détection d'interférence étant conçue pour appliquer un autre critère de désactivation sur la base d'un comportement de convergence de ladite autre séquence $z_0[n]$ dudit autre zéro dudit autre étage de filtre coupe-bande bipolaire pour contourner ledit autre étage de filtre bipolaire (200b, 200c) lorsque ledit autre critère de désactivation est satisfait.

9. Filtre coupe-bande adaptatif conformément à la revendication 8 comprenant en outre un autre filtre passe-bas (341b, 341 c) pour recevoir ladite autre séquence $z_0[n]$ et pour fournir ledit autre signal à l'unité de commande de détection d'interférence.

10. Système de filtre coupe-bande adaptatif conformément à la revendication 8 ou 9, dans lequel ladite unité de commande de détection d'interférence est conçue pour appliquer ledit autre critère de désactivation indépendamment dudit critère de désactivation.

11. Récepteur comprenant :

une section frontale conçue pour recevoir un signal de radiofréquence analogique et pour émettre un signal numérique converti vers le bas ; et
un système de filtre coupe-bande adaptatif conformément à l'une quelconque des revendications 1 à 10 et connecté de façon à recevoir ledit signal numérique converti vers le bas, ledit filtre coupe-bande adaptatif étant conçu pour émettre de manière sélective ledit signal numérique converti vers le bas ou une version filtrée de celui-ci, et
une unité de traitement de signal connectée de façon à recevoir un signal de sortie dudit filtre coupe-bande adaptatif.

12. Récepteur conformément à la revendication 11, dans lequel ledit signal de radiofréquence analogique est un signal d'un système mondial de localisation.

13. Procédé pour réduire un signal d'interférence par un filtre coupe-bande, procédé comprenant :

l'adaptation d'un zéro complexe et du conjugué complexe de celui-ci d'un étage de filtre coupe-bande bipolaire (300) pour isoler une composante de fréquence réelle dudit signal d'interférence dans un signal d'entrée numérique,
la détermination d'un comportement de convergence d'une séquence $z_0[n]$ représentant une estimation d'un zéro complexe de l'étage de filtre coupe-bande bipolaire à chaque instant n, et
l'utilisation d'un critère de désactivation sur la base dudit comportement de convergence du complexe zéro pour contourner de manière sélective ledit étage de filtre bipolaire.

14. Procédé conformément à la revendication 13, dans lequel la détermination dudit comportement de convergence comprend l'estimation d'un module desdits zéros complexes.

**15.** Procédé conformément à la revendication 14, dans lequel ledit critère de désactivation est établi par détermination d'une valeur seuil pour le module desdits zéros complexes.

**16.** Procédé conformément à la revendication 14 ou 15, dans lequel l'estimation du module de zéros complexes comprend l'établissement de moyenne de ladite séquence de $z_0$.

**17.** Procédé conformément à la revendication 16, dans lequel l'établissement de moyenne de ladite séquence $z_0$ comprend l'exécution d'un procédé de filtrage passe-bas.

**18.** Procédé conformément à l'une quelconque des revendications 13 à 17, dans lequel l'adaptation desdits zéros complexes comprend la compensation de l'effet des deux zéros complexes par l'utilisation de deux pôles comportant la même phase par comparaison aux zéros complexes.

**19.** Procédé conformément à la revendication 18, dans lequel un module des deux pôles est contracté par un facteur prédéfini par comparaison avec le module des zéros complexes.

**20.** Procédé conformément à l'une quelconque des revendications 13 à 19, dans lequel lesdits zéros sont adaptés par détermination d'une puissance de sortie minimale dudit signal filtré.

**21.** Procédé conformément à l'une quelconque des revendications 13 à 20, comprenant en outre l'entrée dudit signal filtré dans au moins un autre étage de filtre coupe-bande bipolaire et l'adaptation d'au moins un autre zéro et d'un complexe conjugué de celui-ci à au moins une autre composante de fréquence réelle dudit signal d'interférence pour fournir au moins un autre signal de sortie filtré.

**22.** Procédé conformément à la revendication 21 comprenant en outre la détermination d'un comportement de convergence d'un module dudit autre zéro à l'aide dudit comportement de convergence déterminé pour sélectionner ledit autre signal de sortie filtré ou ledit signal de sortie filtré entré dans ledit autre étage de filtre coupe-bande bipolaire pour un autre traitement de signal.

**notch filter
transfer function**

**Fig. 1a**

**Fig. 1b**

**Fig. 2a**

**Fig. 2b**

**Fig. 2c**

**Fig. 2d**

Fig. 2e

Fig. 2f

**Fig. 2g**

**Fig. 2h**

Fig. 2i

Fig. 2j

Fig. 2k

Fig. 2l

Fig. 2m

**Fig. 2n**

**Fig. 2o**

Fig. 2p

Fig. 2q

**Fig. 2r**

**Fig. 2s**

**Fig. 2t**    digital frequencies

**Fig. 2u**    numerical frequencies

**Fig. 2v**

numerical frequencies

**Fig. 2w**

numerical freqencies

**Fig. 2x**

numerical frequencies

**Fig. 3a**

**Fig. 3b**

interference to noise ratio
J/N (dB)

**Fig. 3c**

**Fig. 3d**

**Fig. 3e**

**Fig. 3f**

**Fig. 3g**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0178242 A2

### Non-patent literature cited in the description

- **V. Calmettes ; R. J. Landry ; M. Bousquet.** impact of interference on a generic GPS receiver and assessment of mitigation techniques. *IEEE 5th International Symposium on Spread Spectrum Techniques and Applications,* September 1998, 87-91
- **V. Calmettes ; F. Pradeilles ; M. Bousquet.** Study and comparison of interference mitigation techniques for GPS receiver. *ION GPS,* September 2001
- Digital Signal Processing Using MATLAB. **V. K. Ingle ; J. G. Proakis.** PWS Book Ware Companion Series. PWS Publishing Company, 1997
- **R. Rifkin ; J.J. Vaccaro.** Comparison of narrowband adaptive filter technologies for GPS. MITRE Corporation, March 2000
- **R. V. Raja Kumar ; R.N. Pal.** Tracking of bandpass signals using centre-frequency adaptive filters. *IEEE Transactions on Acoustics, Speech, and Signal Processing,* October 1990, vol. 38 (10), 1710-1721
- **P. Stoica ; A. Nehorai.** Performance analysis of an adaptive notch filter with constrained poles and zeros. *IEEE Transactions on Acoustics, Speech and Signal Processing,* June 1988, vol. 36 (6), 911-919
- **R. Jr Landry ; V. Calmettes ; M. Bousquet.** Piranha filter for communication system robustness. *IEEE international Conference on Acoustics, Speech, and Signal Processing,* March 1999, vol. 3, 1517-1520